# EUROPEAN PATENT SPECIFICATION

(11) **EP 4 511 643 B1**
(45) Date of publication and mention of the grant of the patent: **25.11.2026**
(21) Application number: 23724350.6
(22) Date of filing: 21.04.2023
(51) Int. Cl.: G01N 23/20008, G01N 23/20091, G01N 23/2251

(54) **IMPROVED X-RAY ANALYSIS FOR HEATED SPECIMENS IN ELECTRON MICROSCOPES**
VERBESSERTE RÖNTGENANALYSE FÜR BEHEIZTE PROBEN IN ELEKTRONENMIKROSKOPEN
ANALYSE AUX RAYONS X AMÉLIORÉE DESTINÉE À DES ÉCHANTILLONS CHAUFFÉS DANS DES MICROSCOPES ÉLECTRONIQUES

(30) Priority: 21.04.2022 GB 202205827
(43) Date of publication of application: 26.02.2025
(73) Proprietor: Oxford Instruments Nanotechnology Tools Limited, High Wycombe HP12 3SE (GB)
(72) Inventor: BHADARE, Santokh, Abingdon Oxon OX13 5QX (GB); MANSOUR, Haithem, Abingdon Oxon OX13 5QX (GB); TYRRELL, Chris, Abingdon Oxon OX13 5QX (GB)
(74) Representative: Gill Jennings & Every LLP
(86) International application number: PCT/GB2023/051065
(87) International publication number: WO 2023/203354

(56) References cited:
- US-A1- 2017 103 868
- US-A1- 2019 242 836

## Description

### FIELD OF THE INVENTION

The present invention relates to a system for improved X-ray analysis of specimens in electron microscopes.

### BACKGROUND

Metallic materials properties vary depending on temperature and mechanical stress. Analysing these materials when subjected to changing temperatures helps understanding phenomena ranging from precipitation to phase transformation and thus allows metallurgists and material scientists to develop new materials with better properties. X-ray analysis of characteristic X-ray emissions using an energy-dispersive spectrometer (EDS) can be used for in-situ heating analysis inside an electron microscope (EM) and more specifically for dynamic in-situ experiments where phenomena like precipitation or phase transformation could be observed in real-time.

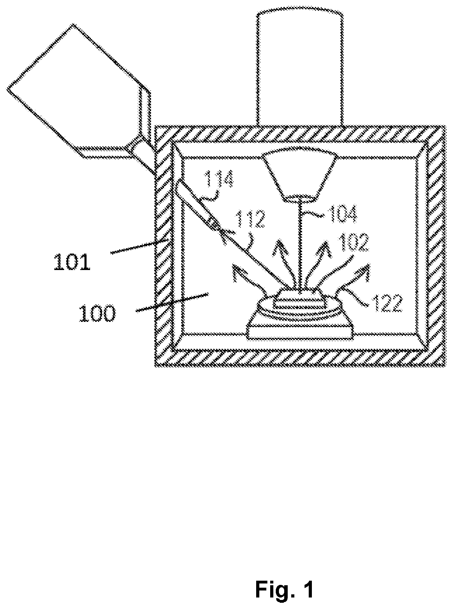

Figure 1 shows a simplified view of a system used for X-ray analysis of heated specimens in an electron microscope. It is the same application as described in US 10,656,106 B2. The system of Figure 1 includes a vacuum specimen chamber 100 bounded by a wall 101 in which a vacuum is obtained during use. During use, a specimen 102 is mounted on a stage such that an incident electron beam 104 excites characteristic X-rays 112 from the specimen 102. The characteristic X-rays 112 are measured by an X-ray detector tube 114 inserted through port in vacuum chamber wall 101.

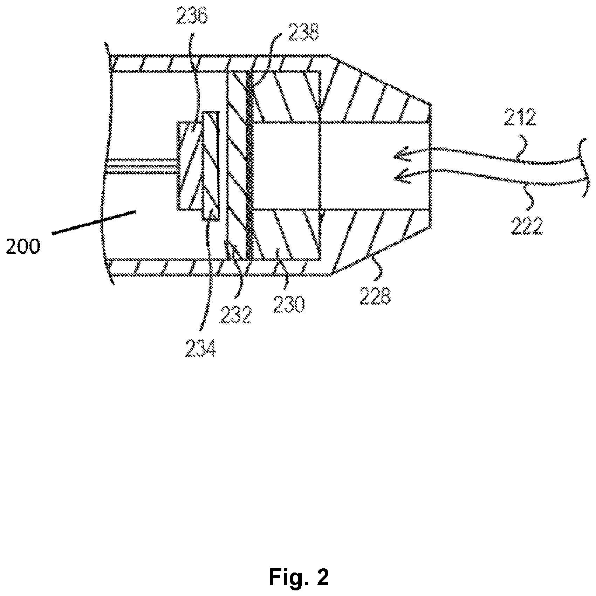

Figure 2 shows a schematic cross section of an EDS detector that would typically be used for X-ray detection. For heating experiments, the stage may use a heating element or heat may be generated by other means such as focussing a laser beam on the specimen 102 and the specimen temperature may typically be increased to more than 100°C but could be 1500°C or even higher depending on the study. However, some components within most types of EDS detector are likely to be damaged if the temperature exceeds 150°C so the EDS detector cannot have any significant thermal connection with the specimen when it is heated well above 150°C. Therefore, for this type of application, the specimen chamber is evacuated to a vacuum 100 of sufficiently low pressure to ensure there is negligible thermal conductivity through convection. In this case, the detector is only exposed to heat (black body) radiation 122 from the specimen 102 and the stage and if this radiant energy can be dissipated by conduction through the body of the detector, the temperature of the EDS detector components can be kept well below 150°C, even when the specimen 102 is heated to much higher temperatures.

EDS analysis in EM is typically conducted at room temperature with the specimen and detector in a vacuum environment. Even though there is no heat convection or conduction through a vacuum, working with a high temperature specimen is more challenging because the black body radiation (IR, visible light, and UV) emitted from the heating device has a big influence on the quality of the recorded X-ray spectrum. At high temperatures (> 600°C), it becomes impossible to collect a useful spectrum as the signal is degraded by noise effects that are a result of black body radiation from the specimen.

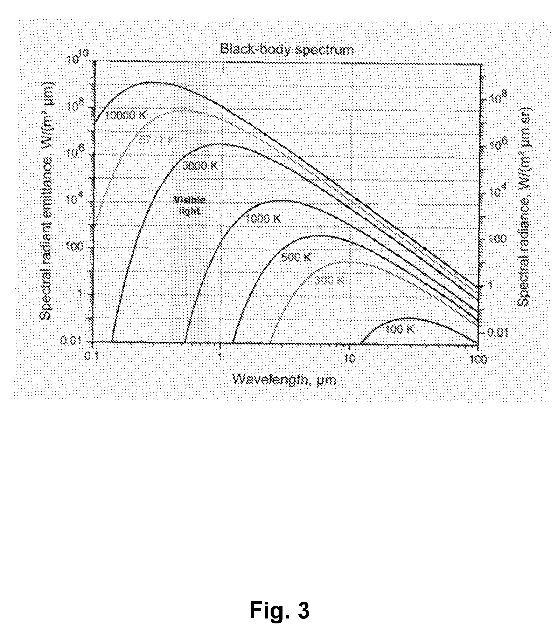

As shown in Figure 2, a conventional EDS detector has a window 232 that provides a barrier to seal the vacuum 200 inside the detector while being as transparent as possible to X-rays. Characteristic X-rays 212 from the specimen 102 and black body radiation 222 from the specimen 102 and stage enter the detector through an entrance collimator 228 in the detector housing, the entrance collimator 228 facing the specimen. The characteristic X-rays 212 from the specimen 102 and black body radiation 222 from the specimen 102 and stage are then incident upon sensor material 234, which typically comprises a semiconductor such as silicon. The detector also includes a cooling element and front-end electronics for the sensor 236, and a magnetic electron trap 230 configured to stop electrons from reaching the window 232. A reflective layer 238 of typically 40 nm of Aluminium is often included within the window structure to block the weak visible light that is emitted when a cathodoluminescent (CL) specimen is struck by an electron beam. Most specimens are not CL, but any specimen emits black body radiation that will increase in intensity if it is heated and the spectral distribution of heat radiation also changes with temperature as shown in Figure 3. The electron trap is not always necessary if the EM electron optics steers backscattered electrons away from the entrance collimator.

The EDS detector system produces a voltage ramp at the output. Each X-ray photon seen by a detector produces a voltage step on the ramp that is proportional to the photon energy and the step height is measured by the electronics. However, light photons have considerably less energy than X-ray photons and do not produce measurable steps on the ramp but they cause the ramp gradient to increase and the ramp gradient is therefore an indication of how much light is reaching the EDS detector.

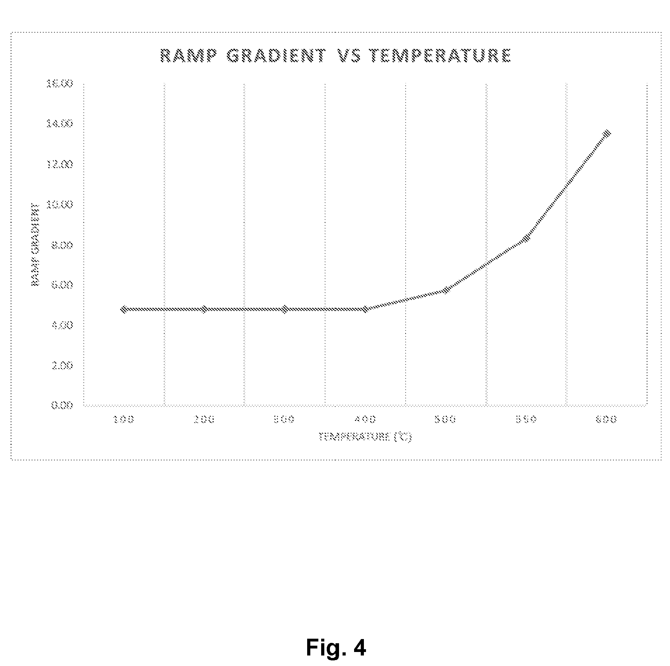

An EDS detector fitted with a standard window with a reflective coating of only 40 nm of aluminium will be sensitive to radiation from a heated specimen. Figure 4 shows there is a considerable increase in ramp gradient detected by a typical EDS detector as the temperature exceeds 560°C (833K). As shown in Figure 3, depending on the temperature, the photons from black body radiation emitted from the sample could be mainly in the infrared wavelength range, the visible light range or the ultraviolet wavelength range and a heating temperature of 833 K (560°C) is approximately the temperature at which visible light radiations (wavelengths from 0.4µm to 0.8µm) start to be emitted. The increase in ramp gradient shown in Figure 4 is therefore an indication that the EDS detector used is much more sensitive to visible light than the longer wavelength emissions. The increase in ramp gradient produces an undesirable effect equivalent to excess electronic noise with a consequent degradation in resolution of the X-ray spectrum so that characteristic emission peaks are more difficult to separate and at some temperature, the spectrum may no longer be useful for X-ray analysis. At this point, the X-ray detector is said to be saturated.

This problem has been addressed in US 10,656,106 B2 where, to reduce the degradation and make the EDS usable at high temperature, a much thicker layer of Aluminium is used as a coating 238 to be a more effective barrier to black body radiation. For example, a silicon nitride membrane is used for the window 232 with an aluminium coating 238 ranging between 50 and 400nm in thickness. Torma et al (IEEE Trans. Nuclear Science, vol 60 no 2 April 2013, 111) describes a "solar blind" window that when fitted to an EDS detector allows it to be operated in day light. One commercial product C1 from Amptek uses 150 nm Si3N4 with 250 nm Aluminium coating for use in room light: (https://www.amptek.com/products/x-ray-detectors/fastsdd-x-ray-detectors-for-xrf-eds/c-series-low-energy-x-ray-windows). These "solar blind" windows were not originally intended for use in EM and were designed for X-ray fluorescence investigations where the specimen is excited by an X-ray tube source of X-rays in day light conditions. Use of an aluminium coating much thicker than 40 nm will reduce black body radiation during the heating experiment, but it has the disadvantage of reducing X-ray transmission for low energy X-rays in particular. Although this reduction in performance for low energy X-rays may be an acceptable sacrifice to allow acquisition of data at high specimen temperatures, it is not desirable when the detector is being used for conventional analysis of specimens that are not heated.

For investigations requiring the specimen to be heated to very high temperatures, new problems arise. As shown in Figure 3, not only does the power of the radiation increase by orders of magnitude, but an increasing portion of the radiation occurs in the visible or UV region of the spectrum so any filter must be able to block light photons of increasingly high energy (shorter wavelength). The increasing radiation load on the detector will cause materials to heat up. In order to maintain a vacuum inside the detector sensor encapsulation, the window must form a seal with the detector housing and this inevitably is achieved by gluing, soldering or welding. The series of materials, window, support grid, window mount, detector housing and any glues or solder, all have different coefficients of thermal expansion so as the radiative load increases, temperature rises, mechanical stress increases and mechanical or chemical breakdown can occur so that the window is damaged. Consequently, the detector may only be able to function in conditions where the window temperature is below 150 degrees C. This restriction places a limit on how close the detector can be to the specimen (to collect a stronger X-ray signal) and the temperature to which the specimen can be heated without damaging the detector.

What is needed is a better solution for X-ray spectroscopy of specimens inside an electron microscope that can allow analysis at very high temperatures (e.g. > 600°C) without significant compromise in X ray detector sensitivity for investigations where the specimen does not need to be heated.

US 2017/103868 A1 discloses a method of examining a specimen in a charged particle microscope and a charged particle microscope in which the method can be enacted.

### SUMMARY OF INVENTION

In accordance with a first aspect of the invention there is provided a system for performing energy dispersive X-ray analysis of a specimen in a particle beam instrument, the system comprising an X-ray detector and a filter member, the system adapted such that in a first operating mode, the filter member and detector are positioned so as to provide an unobstructed line of sight between the specimen and the detector, and in a second operating mode, the filter member and detector are positioned so as to obstruct the line of sight between the specimen and the detector such that in use, the portion of black body radiation emitted from the specimen that is incident upon the detector is attenuated.

It has been found that employing a system having this configuration can provide significant improvements to the EDS analysis of specimens. Firstly, the system can be easily switched between two distinct operating modes, with the first mode providing an unobstructed line of sight between the specimen and the detector such as to maximise X-ray detection sensitivity, and the second mode having the line of sight obstructed by a filter member so that in the second mode of operation, black body radiation emitted from the specimen and other heated components of the system is attenuated. Following the theory provided in the background section above, employing a system having this configuration is particularly useful in applications where the analysis of both heated and room temperature specimens is to be performed.

The second mode of operation may be employed in performing EDS analysis of a heated specimen to attenuate the portion of black body radiation incident upon the detector to reduce degradation in the resolution of the X-ray spectrum such that characteristic emission peaks can still be identified and separated. The point at which the X-ray detector can no longer output a meaningful system for EDS analysis may be referred to herein as the X-ray detector becoming saturated. The second mode of operation of the system is therefore employed in use for analysing heated specimens to prevent the X-ray detector becoming saturated by the black body radiation.

The first mode of operation may be employed in performing EDS analysis of a room temperature specimen to maximise the sensitivity of the X-ray detector when black body radiation is negligible.

It will be understood that, in the context of this disclosure, a particle beam instrument may be thought of as a device being configured to generate the focussed particle beam, for example an electron beam, as a source of X-ray excitation to perform energy dispersive X-ray analysis of a specimen. The detector sensor area could typically range from 10 mm² to 170 mm² and the filter member is typically designed to suit the area of sensor being used.

Typically, the X-ray detector is a semiconductor X-ray detector and includes sensor elements can be used to monitor X-ray photon energies. The area including the sensor elements may be referred to herein as an active area of the X-ray detector. The sensors may be adapted to measure, or otherwise provide or output a signal or data representative of the detection or energies of received X-ray photons. In this way, the sensor elements may be configured both to detect individual received X-ray photons and to monitor energies of individual received X-ray photons.

The term "filter member" in all aspects of the disclosure is intended to refer to a component or group of components of the system being adapted for the purpose of filtering electromagnetic radiation, and in particular filtering electromagnetic radiation corresponding to black body radiation emitted from a heated specimen, particularly in the infrared, visible and ultraviolet bands. The filter member may additionally attenuate radiation, typically in the visible band, originating from the cathodoluminescence of a cathodoluminescent specimen. The filter member includes filter material of a suitable composition and geometry such that the filter member provides a wavelength dependent attenuation profile for incident electromagnetic radiation. Although certain specific examples of composition and geometry are detailed below, it will be understood that other compositions and geometries which exhibit a suitable wavelength dependent attenuation profile may be employed based on the required application.

The filter member in all aspects of the disclosure may alternatively be referred to as a filter assembly. The filter member or assembly may comprise one or more components, including the filter material. The filter material is typically provided as a film, membrane, or window member comprising the said material. The filter material may be comprised in a filter material element, the filter material element being a component of the filter member and comprising the filter material and a support structure or element, for instance a ring or frame in which the filter material is mounted or fixed, to facilitate handling of the filter window. The filter material element may also comprise a supporting grid upon which the filter material is disposed.

The "first operating mode" and "second operating mode" are intended to refer to modes of operation in which the system may be used to perform EDS analysis. In particular, the two modes may refer to two different configurations in which the system can be operated, wherein the positioning of at least one of the X-ray detector and filter member is different between the modes. The term "positioned" when referring to the positioning of the X-ray detector and the filter member will be understood as referring to their relative positioning with respect to one another. The first operating mode is typically employed when analysing a room temperature specimen, and the second operating mode is typically employed when analysing a heated specimen.

In the first operating mode, an unobstructed line of sight between the filter member and an active area of the detector is provided by the relative positioning of the detector and the filter member. This may be thought of as there being at least one unobstructed line of sight provided between a portion of the specimen and an active area of the detector and therefore includes the filter member partially obscuring the detector from some portions of the specimen. Preferably, in the first operating mode, multiple lines of sight between a portion of the specimen and an active area of the detector are unobstructed in the first operating mode so as to provide an unobstructed solid angle within which all lines of sight are unobstructed.

Preferably in the first operating mode, all lines of site between the specimen and an active area of the X-ray detector are unobstructed. In other words, in this configuration, no portions of the specimen are obscured by the filter member which advantageously permits unrestricted visibility or access to the incident location of the particle beam and prevents the absorption of low energy X-rays emitted from the specimen such that the sensitivity of X-ray detection by the detector is maximised.

In the second operating mode, the relative positioning of the detector and the filter member is such that the unobstructed line of sight provided between the filter member and an active area of the detector in the first operating mode is obstructed. In other words, a greater portion of the specimen is obscured from the detector by the filter member in the second operating mode than in the first operating mode. However, it will be understood that the filter member may still partially obscure the detector from some portions of the specimen in the second operating mode.

Preferably, in the second operating mode, all lines of site between the specimen and an active area of the X-ray detector are obstructed. In other words, in this configuration, all portions of the specimen are obscured by the filter member such that the attenuation of black body radiation emitted from the specimen in maximised, minimising its effect on the resolution of the X-ray analysis. This may be achieved, for example, by the system being configured to position the filter member over the entrance collimator of the X-ray detector in the second operating mode.

Employing the system to operate in the first operating mode or the second operating mode may be performed by altering a relative positioning of the X-ray detector and the filter member through movement of at least one of the detector and the filter member such that the portion of the active sensor area of the detector obstructed by the filter member is changed.

In some examples, the filter member is movable between a first position relative to the detector corresponding to the first operating mode and a second position relative to the detector corresponding to the second operating mode. In these examples, the X-ray detector may be located at the same position in the first and second operating modes. Alternatively, or additionally to the above-described feature, the detector may be movable between a first position relative to the filter member corresponding to the first operating mode and a second position relative to the filter member corresponding to the second operating mode. In these examples, the filter member may be located at the same position in the first and second operating modes. In both the above sets of examples, the relative positioning of the detector and filter member can be adapted such that the system can operate in use in the first operating mode and second operating mode.

In some examples, the system is adapted such that in the first operating mode, the detector is positioned closer to the specimen than in the second operating mode. Advantageously, having the detector positioned closer to the specimen in the first operating mode increases the solid angle for the collection of X-rays, whereas having the detector positioned further from the specimen in the second operating mode reduces incident power of black body radiation emitted from the specimen upon the detector, reducing the amount of attenuation that the filter member is required to provide to obtain a spectrum useful for X-ray analysis.

In some examples, the system comprises a mounting element, the mounting element comprising an aperture, and the filter member being removably attachable to the mounting element across the aperture. The "mounting element" may be understood as a component of the system adapted to receive a filter member such that when mounted, the filter member at least partially covers the aperture. The mounting element may be, for example, a flap or a shutter mechanism.

In preferable examples, the mounting element is movable between a first position relative to the detector corresponding to the first operating mode and a second position relative to the detector corresponding to the second operating mode. The mounting element may be embodied as a flap attached to a housing of the system at a first point such that the flap is movable about the attachment point. In this way, the portion of the detector active area obstructed by the filter member may be changed through movement of the mounting element such that the system can be simply changed between operating in the first operating mode and the second operating mode.

To allow movement of the mounting element and provide a consistent first position and second position corresponding to the two operating modes, in some examples, the mounting element is biased towards the second position by a resilient biasing element, wherein the biasing element is typically a spring tension mechanism. The spring tension mechanism is typically configured to hold the mounting element in the second position. A force may then be applied to the mounting element by the system to actuate movement of the mounting element from the second position to the first position. Alternatively, the mounting element may be supported on a hinge where the mounting element and hinge are adapted such that gravity holds the mounting element in the second position. A force may then be applied to the mounting element by the system to actuate movement of the mounting element from the second position to the first position.

Actuating movement of the mounting element between the first position and the second position may be performed manually, under motorised control, or by another component of the system. In some examples, the system further comprises a motor, wherein the motor is configured to actuate movement of the mounting element between the first position relative to the detector and the second position relative to the detector. In this way, the mounting element may be conveniently repositioned between the first and second positions for switching between the first mode of operation and the second mode of operation. Alternatively, the movement of the mounting element may be actuated by the movement of another component of the system. In some examples, the X-ray detector is mounted to a support arm, the support arm movable along a mechanical slide between a first position relative to the filter member and a second position relative to the filter member such that movement of the support arm from the second position to the first position towards the specimen actuates the mounting element to move between the second position and first position. Typically, when the mounting element is embodied as flap as described above, the movement of the support arm towards the specimen results in a part of the support arm contacting the mounting element and providing a force actuating the mounting element to move from the second position to the first position. Where the mounting element is biased towards the second position, the contact force acts against the biasing of the mounting element. Equivalently, as the support arm is retracted from the first position to the second position away from the specimen, the biasing of the mounting element in the absence of a contact force returns the mounting element to the second position.

In some examples, the system further comprises a shutter mechanism, the shutter mechanism configured to move the filter member or a component of the filter member between a first position relative to the detector corresponding to the first operating mode and a second position relative to the detector corresponding to the second operating mode. The "shutter mechanism" may be understood as a component adapted to change the portion of the active area of the X-ray detector obstructed by the filter member such that the system can be changed between the first operating mode and the second operating mode by actuating the shutter mechanism, thus providing a convenient means of switching the system between operating modes.

In some examples, the filter member is configured to hold a filter material element in place by at least one of a friction fit, a clearance fit, and a transition fit. Advantageously, a filter member is provided in which thermal expansion and contraction of the filter material element is accommodated, namely by permitting changes to any of the size, position, and one or more dimensions of the filter material element, relative to one or more other parts of the filter member, for example relative to a filter cap thereof, without mechanical stresses arising within the filter material as would occur if the element were adhered or otherwise unyieldingly affixed to the filter member. Since the filter member is suited for use in analysis involving varying temperatures, the inventors have found that this arrangement for holding the filter material element, in which damaging thermal expansion effects are mitigated, enables the element to undergo a significantly greater number of thermal cycles before it requires replacement.

In some examples, the filter member further comprises a removable cap, the removable cap adapted to be fitted to the system, the filter member being configured such that a filter material element is removably mountable to the removable cap. The filter material element may be directly mountable to the removable cap, or indirectly mountable via a component of the filter member or assembly to which the filter material element, which is typically provided as a window element, is affixed or otherwise coupled. Typically, the cap comprises an opaque material and an aperture and the filter material is preferably removably mountable such that in use the filter material is disposed across the aperture. In these examples, since the filter member is removably attachable to the mounting element, the filter member or filter material element can be easily changed or replaced, for example in the event of damage.

In some examples according to any of the aspects set out in this disclosure, the filter member comprises a resilient element adapted such that in use, the resilient element exerts a force on a filter material element such that the filter material is held in position. The filter member or assembly may be arranged such that the resilient element exerts a force directly upon the filter material, or indirectly upon it, for instance by contact between the resilient element and the filter material element or a component of the filter member or assembly to which a filter material window or other filter material element is affixed or otherwise coupled. In these examples, because the filter material is held in position by a resilient element rather than being glued, welded or soldered, the filter member can withstand higher head loads as it is free to thermally expand or contract without the additional mechanical stress that would be observed with a glue, weld or solder joint. In preferable examples of this arrangement, the filter member comprises a front cap portion, spring element, back cap portion, and a screw fitting for attaching the front cap portion to the back cap portion, wherein the filter member is configured such that the filter material element can be held in place by friction against the spring element when the front cap portion is screwed together with the back cap portion. In this way, the filter material element is both free to thermally expand and contract whilst also being easily replaceable, for example in the event of damage.

In some examples, the filter member comprises a slot adapted to receive a filter material element such that the filter material element forms a clearance fit with the filter member. It will be understood that the filter member may be adapted to receive the filter material element directly, or receive the filter material element indirectly via a component of the filter member or assembly to which the filter material window or other filter material element is affixed or otherwise coupled. In these examples, the interior surface of the slot of the filter member may comprise one or more guiding elements adapted to assist in centring the filter material element across an aperture of the filter member. In some examples, the filter material element may be further affixed in position across the aperture by a splint or screw.

In some examples, the filter member further comprises a magnetic electron trap. Typically, the magnets are positioned closer to the specimen than a filter material element such that any backscattered electrons from the specimen are trapped before they can excite any X-rays from the filter material. It will be understood that the functionality of the magnetic electron trap above may alternatively be provided using electric fields or a combination of magnetic and electric fields. In preferable examples, the filter member is adapted such that a filter material element is insertable in a space between the electron trap and the detector. The filter material element may be directly insertable, or indirectly insertable via a component of the filter member or assembly to which the filter material window or other filter material element is affixed or otherwise coupled. This can be achieved manually or with the filter material element on a motorised slide. This arrangement avoids excitation of X-rays from the filter material and allows the same electron trap to be used whether the filter material element is inserted or removed from the space in the filter member.

In some examples, the filter member comprises a window member comprising or formed from a filter material. Preferably the average thickness, along the direction between the specimen and the detector, of the window member or a filter material later thereof, is greater than or equal to 100 nm. The "thickness" here will be understood as referring to a total average thickness, for example including all layers of the filter material if the filter member comprises multiple layers. It has been shown that a thickness of 100 nm to 1000 nm is suitable depending largely on the choice of filter material and the specimen temperature when performing analysis of heated specimens. It will be understood that this window member, which may also be thought of as a filter material window or a filter membrane, is preferably provided as a filter material element with a support structure or element, for instance a ring or frame in which the filter material is mounted or fixed, to facilitate handling of the filter window.

In some examples, the filter member comprises any one or more of silicon nitride, polymer, aluminium, beryllium, carbon, or graphene. It has been shown that these materials, when arranged in suitable geometries and/or combinations, achieve the required attenuation of black body radiation improve the resolution of X-ray spectrums when analysing heated specimens.

Specifically, in some examples, the filter member comprises silicon nitride or polymer with a coating of at least 200 nm of aluminium, or beryllium foil. Alternatively, in some examples, the filter member comprises carbon or multiple layers of graphene, with an average thickness along the direction between the specimen and the detector thickness of between 100 nm and 1000 nm. It has been shown that these combinations of materials and geometries achieve the required attenuation of black body radiation improve the resolution of X-ray spectrums when analysing heated specimens.

In accordance with a second aspect of the invention there is provided a method of performing energy dispersive X-ray analysis of a specimen according to the first operating mode of the system according to the first aspect or any implementation of the first aspect, the method comprising: positioning a specimen on a specimen stage inside a specimen chamber of the system; using a particle beam assembly to generate a focused particle beam; and monitoring, using the X-ray detector, energies of X-ray photons generated by interaction between the particle beam and the specimen.

The method according to the second aspect Involving operating the system in the first mode of operation may be employed in performing EDS analysis of a room temperature or cold specimen to maximise the sensitivity of the X-ray detector.

Preferably, after positioning the specimen, the specimen chamber may be evacuated such that a pressure inside the chamber is lower than an ambient pressure.

Advantages associated with the different implementations of the first aspect are the same are applicable to the second aspect described above.

In accordance with a third aspect of the invention there is provided a method of performing energy dispersive X-ray analysis of a specimen according to the second operating mode of the system according to any one of claims 1 to 25, the method comprising: positioning a specimen on a specimen stage inside a specimen chamber of the system; heating the specimen to a temperature greater than or equal to 100°C; using a particle beam assembly to generate a focused particle beam; and monitoring, using the X-ray detector, energies of X-ray photons generated by interaction between the particle beam and the specimen.

The method according to the third aspect involving operating the system in the second mode of operation may be employed in performing EDS analysis of heated specimens to attenuate the portion of black body radiation incident upon the detector and such as to reduce degradation in the resolution of the X-ray spectrum so that characteristic emission peaks can be identified and separated. Preferably, after positioning the specimen, the specimen chamber may be evacuated such that a pressure inside the chamber is lower than an ambient pressure.

Advantages associated with the different implementations of the first aspect are applicable to the third aspect described above.

In preferable examples of the third aspect, heating the specimen to a temperature greater than or equal to 100°C further comprises heating the specimen to a temperature greater than or equal to 600°C. In other examples, heating the specimen to a temperature greater than or equal to 100°C further comprises heating the specimen to a temperature greater than or equal to 1500°C. It has been shown that employing the system according to the first aspect enables successful EDS analysis to be performed on heated specimens at these temperatures.

In a fourth aspect of the invention there is provided a filter member suitable for attachment to a system for performing energy dispersive X-ray analysis of a specimen, the filter member being removably attachable to the system at a position between the specimen and a detector of the system, the filter member comprising a filter material element, and being configured to hold the filter material element in place by at least one of a friction fit, a clearance fit, and a transition fit. Advantageously, a filter member is provided in which thermal expansion and contraction of the filter material element is accommodated, namely by permitting changes to any of the size, position, and one or more dimensions of the filter material element, relative to one or more other parts of the filter member, for example relative to a filter cap thereof, without mechanical stresses arising within the filter material as would occur if the element were adhered or otherwise unyieldingly affixed to the filter member. Since the filter member is suited for use in analysis involving varying temperatures, the inventors have found that this arrangement for holding the filter material element, in which damaging thermal expansion effects are mitigated, enables the element to undergo a significantly greater number of thermal cycles before it requires replacement.

In some examples, the filter member comprised by the system of the first aspect is a filter member according to the fourth aspect.

In some examples, the filter member comprises a removable cap. It may be configured such that the filter material element is removably mountable to the removable cap.

By employing a filter member where the filter material element is removably mountable rather than being glued, welded or soldered, the filter member can withstand higher head loads as it is free to thermally expand or contract without causing additional mechanical stress as would be observed with a glue, weld or solder joint. This allows the filter member to be positioned closer to a heated specimen and it has been found that the filter member typically be brought as close as 20 mm from the specimen.

In some examples, the filter material element is removably mountable to the removable cap, and to any one or more components of the filter member, by an interference fit. Fastening the filter element into its mounted position within the filter member in this way, so that it is held by friction, preferably instead of adhesion, welding, soldering, or other types of more immovable fixing, alleviates the problem of material strain and stress that would otherwise be caused to the filter material as a result of thermal expansion and contraction. In preferred examples, the filter material element is held in its mounted position without any adhesive or similarly permanent joint, and more preferably is held solely by friction.

In some examples, the filter member comprises a resilient element adapted such that in use, the resilient element exerts a force on a filter material element such that the filter material is held in position.

The filter member or assembly may be arranged such that the resilient element exerts a force directly upon the filter material, or indirectly upon it, for instance by contact between the resilient element and the filter material element or a component of the filter member or assembly to which a filter material window or other filter material element is affixed or otherwise coupled.

A "resilient element" in all aspects of the disclosure will be understood as a component adapted to provide a restoring force when deformed from its equilibrium state or displaced from its equilibrium position. Typically, the restoring force is provided at one or more contact points between the resilient element and the filter material or filter material element, where the restoring force is generated through compression of the resilient element at the contact points with the filter material or filter material element which itself is in contact at an opposite face with a housing of the filter member or assembly. In this way, friction holds the filter material in place. The filter member or assembly may be arranged such that the resilient element exerts a force directly upon the filter material, or indirectly upon it, for instance by contact between the resilient element and a component of the filter member or assembly to which a filter material window or other filter material element is affixed or otherwise coupled.

In some examples, the filter member is adapted such that the filter material element forms a clearance fit with the filter member. This again allows the filter material element to freely thermally expand or contract without causing additional mechanical stress. In some examples, the filter member comprises a slot adapted to receive a filter material element such that the filter material forms a clearance fit with the filter member. It will be understood that the filter member may be adapted to receive the filter material element directly or receive the filter material element indirectly via a component of the filter member or assembly to which the filter material window or other filter material element is affixed or otherwise coupled. In these examples, the interior surface of the slot of the filter member may comprise one or more guiding elements adapted to assist in centring the filter material element across an aperture of the filter member. In some examples, the filter material element may be further affixed in position across the aperture by a splint or screw. It is envisaged that a combination of an interference or friction fit, and a clearance fit may be employed to hold the mounted filter material element in place. For instance, the filter material element may be held within a mounting element by way of a pressed fit, and that mounting element may be receivable by the filter member and may be held therein by way of a clearance fit. Any of these joints may be effected by any of a clearance fit, a transition fit, and an interference fit. Advantageously, such arrangements avoid the potential damage that may be suffered by filter components, particularly the filter material element, when undergoing heating or cooling.

The filter material element may be directly mountable to the removable cap, or indirectly mountable via a component of the filter member or assembly to which the filter material window or other filter material element is affixed or otherwise coupled. Typically, the cap comprises an opaque material and aperture and the filter material is removably mountable across the aperture. In these examples, since the filter member is removably attachable to the mounting element, the filter member can be easily changed or replaced, for example in the event of damage. In preferable examples of this arrangement, the filter member comprises a front cap portion, spring element, back cap portion, and a screw fitting for attaching the front cap portion to the back cap portion, wherein the filter member is configured such that the filter material can be held in place by friction against the spring element when the front cap portion is screwed together with the back cap portion. In this way, the filter material element is both free to thermally expand and contract whilst also being easily replaceable, for example in the event of damage.

In some examples, the filter member further comprises a magnetic electron trap. Typically, the magnets are positioned closer to the specimen than a filter material element such that any backscattered electrons from the specimen are trapped before they can excite any X-rays from the filter material. In preferable examples, the filter member is adapted such that the filter material is insertable in a space between the electron trap and the detector. The filter material may be directly insertable, or indirectly insertable via a component of the filter member or assembly to which the filter material window or other filter material element is affixed or otherwise coupled. This can be achieved manually or with the filter on a motorised slide. This arrangement avoids excitation of X-rays from the filter material and allows the same electron trap to be used whether the filter is inserted or removed from the space in the filter member.

In some examples, the filter member comprises a window member comprising or formed from a filter material. Preferably, the average thickness, along the direction between the specimen and the detector, of the window member or a filter material later thereof, is greater than or equal to 100 nm. The "thickness" here will be understood as referring to a total average thickness, for example including all layers of the filter material if the filter comprises multiple layers. It has been shown that a thickness of 100 nm to 1000 nm is suitable depending largely on the choice of filter material and the specimen temperature when performing analysis of heated specimens. It will be understood that this window member, which may also be thought of as a filter material window or a filter membrane, is preferably provided with a support structure or element, for instance a ring or frame in which the filter material is mounted or fixed, to facilitate handling of the filter window.

In some examples, the filter member comprises any one or more of silicon nitride, polymer, aluminium, beryllium, carbon, or graphene. It has been shown that these materials, when arranged in suitable geometries and/or combinations, achieve the required attenuation of black body radiation improve the resolution of X-ray spectrums when analysing heated specimens.

Specifically, in some examples, the filter comprises silicon nitride or polymer with a coating of at least 200 nm of aluminium, or beryllium foil. Alternatively, in some examples, the filter comprises carbon or multiple layers of graphene, with an average thickness along the direction between the specimen and the detector thickness of between 100 nm and 1000 nm. It has been shown that these combinations of materials and geometries achieve the required attenuation of black body radiation improve the resolution of X-ray spectrums when analysing heated specimens.

More generally, and in any of aspects according to this disclosure, the filter material element may be adapted, that is it may comprise any suitable material and may have any suitable dimensions, to attenuate the portion of black body radiation emitted from an analysis specimen that is incident upon the detector in use. The degree of attenuation that the filter element is adapted to achieve may be chosen in accordance with one or more characteristics of the detector, one or more operating conditions, and/or the specimen.

### BRIEF DESCRIPTION OF DRAWINGS

Examples of the present invention will now be described, with reference to the accompanying drawings, in which like features are denoted by like reference signs, and in which:
Figure 1 shows a schematic for X-ray analysis of a heated specimen in an electron microscope according to the prior art.
Figure 2 shows a schematic cross section through a typical EDS X-ray detector according to the prior art.
Figure 3 shows emission curves of black-body radiation at different temperatures.
Figure 4 shows ramp gradient seen by a conventional EDS detector at different specimen temperatures.
Figure 5 shows a schematic assembly for an additional filter cap to use for analysis of a heated specimen according to an example of the invention.
Figure 6 shows an additional filter cap mounted on the entrance collimator of the X-ray detector according to an example of the invention.
Figure 7 shows an x-ray detector in a second position suitable for analysis of heated specimens according to an example of the invention.
Figure 8 shows an x-ray detector in a first position suitable for measurements where the specimen sample is not heated according to an example of the invention.
Figure 9 shows a calculated optical transmission for a 1000 nm thick carbon film compared to a 250 nm aluminium layer.
Figure 10 shows x-ray transmission curves for a 1000 nm thick carbon film and a 150 nm silicon nitride film coated with 250 nm aluminium supported on a thick silicon grid with 80 % open space.

### DETAILED DESCRIPTION

With reference to the abovementioned figures, examples of methods according to the invention are now described which reduce the influence of black body radiation on the EDS detector when the specimen is heated to high temperatures (>600°C), preferably very high temperatures (>1000°C) and most preferably extremely high temperatures (>1500°C) without significantly compromising capability to analyse specimens at room temperature, for example, not reducing low energy sensitivity or spectrum peak resolution.

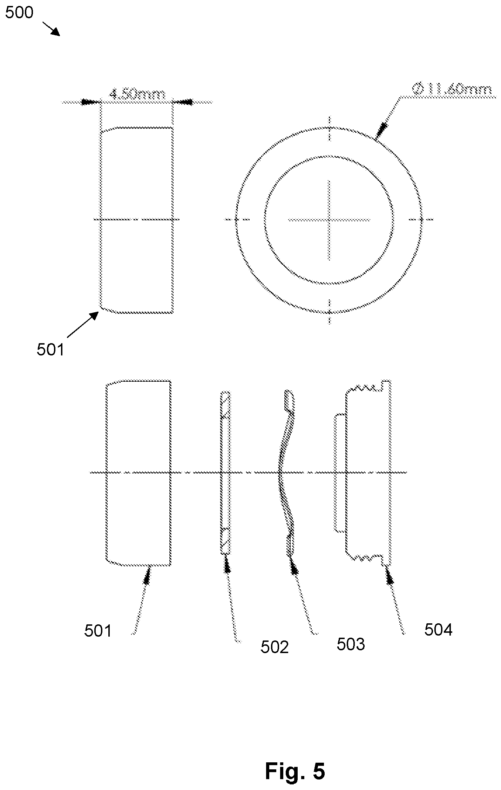

The below described examples of a system for performing energy dispersive X-ray analysis of a specimen in a particle beam instrument retain the use of a conventional window, with good low-energy X-ray transmission to seal the vacuum on the detector, but interpose a separate additional filter member between the detector and the specimen when the detector is required to investigate a heated specimen. When this additional filter member is in place, it is closer to the specimen than the detector and will experience much higher heat load than the window on the detector. The additional filter member does not have to form a vacuum seal with the detector housing and if the additional filter member is damaged, it can be replaced without having to repair the X-ray detector. Furthermore, if the additional filter member or any components of the filter member can be held in place without the use of glues or solder, mechanical stresses due to the different coefficients of thermal expansion can be significantly reduced so that the additional filter member can be operated at higher temperature than a conventional X-ray detector window. The filter member may include a filter material element that can be mounted on a removable cap, the removable cap being suitable to be fitted to the end of the detector housing. Figure 5 shows one embodiment of such a cap.

Figure 5 illustrates an example of a filter member embodied as a cap 500, the cap 500 including a front cap portion 501, a filter material element 502, a spring element 503 and a back cap portion 504. In Figure 5, the filter material element 502 is not glued, welded or soldered to the cap 500 but is held in place by friction against the spring element 503 when the front cap portion 501 is screwed together with the back cap portion 504. The filter material element 502 can thus expand and contract with change in temperature without causing any mechanical stress. Thus, if the filter material itself is stable, the cap 500 can sustain much higher temperatures than with a filter held in place with glue or a weld. Whilst a spring element 503 is illustrated as a spring washer in Figure 5, the spring element 503 may comprise any resilient element adapted to exert a force on the filter material element 502 such that the filter material is held in position. It will be also understood that the spring element 503 may be positioned between the back cap portion 504 and filter material element 502 as shown in the exploded view of Figure 5, or alternatively may be positioned between the front cap portion 501 and the filter material element 502.

In some examples, the filter member may not include a spring element 503 and instead may be adapted such that the filter material element 502 is held in position in a slot between the front cap portion 501 and back cap portion 504 by way of a clearance fit such that the filter material element can expand and contract with change in temperature without causing any mechanical stress. Where the spring element 503 is not provided, one or more of the front cap portion 501 and back cap portion 504 may comprise one or more guiding elements adapted to assist in centring the filter material element 502 across the aperture of the removable cap as the front cap portion 501 and back cap portion 504 are screwed together. In further examples, the filter material element 502 may be further affixed in position by a splint or screw.

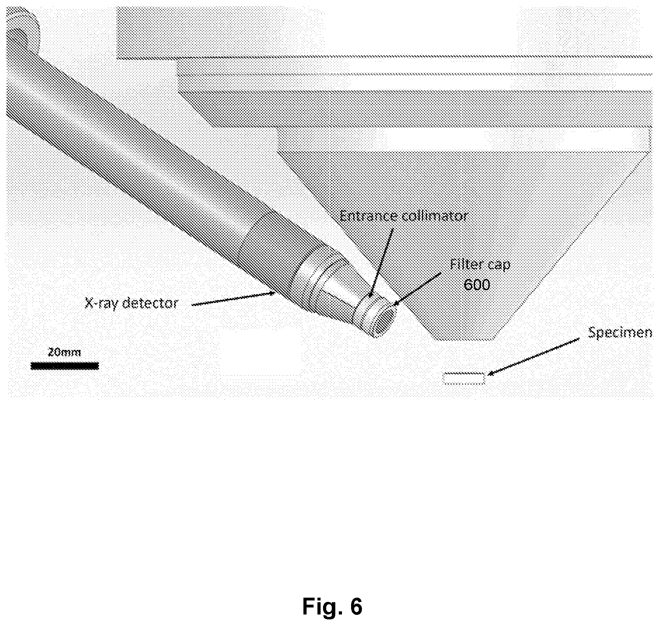

Figure 6 is a pictorial view showing the additional filter cap 600 mounted on the end of a conventional X-ray detector in preparation for an investigation of a heated specimen. The filter cap 600 may be, for example, the filter cap 500 illustrated in Figure 5. The filter cap 600 does not have to be glued or welded to the detector and the back cap portion can be a simple friction fit on to the end of the entrance collimator. During the investigation the front cap portion could typically be brought as close as 20 mm from the specimen. The detector sensor area could typically range from 10 mm² to 170 mm² and the filter cap 600 can be designed to suit the area of sensor being used. In another variant, the filter cap 600 can include a magnetic electron trap and the magnets are positioned closer to the specimen than the filter; with this variant any backscattered electrons from the specimen are trapped before they can excite any X-rays from the filter material. In a further variant, since the electron trap magnet is outside of the detector vacuum, the filter material can be inserted in a slot in a space between the magnet and the detector. This can be achieved manually or with the filter material element on a motorised slide. This arrangement again avoids excitation of X-rays from the filter material and the same electron trap can be used whether the filter material element is inserted or removed from the slot.

When the additional filter member and filter material element is in place, the black body radiation from the heated specimen is attenuated sufficiently to allow a useful X-ray spectrum to be acquired, although the filter member will absorb some of the X-ray photons, particularly those at lower energy. For analysis of specimens that are not heated, the filter cap 600 can be removed to restore the X-ray detector sensitivity to normal.

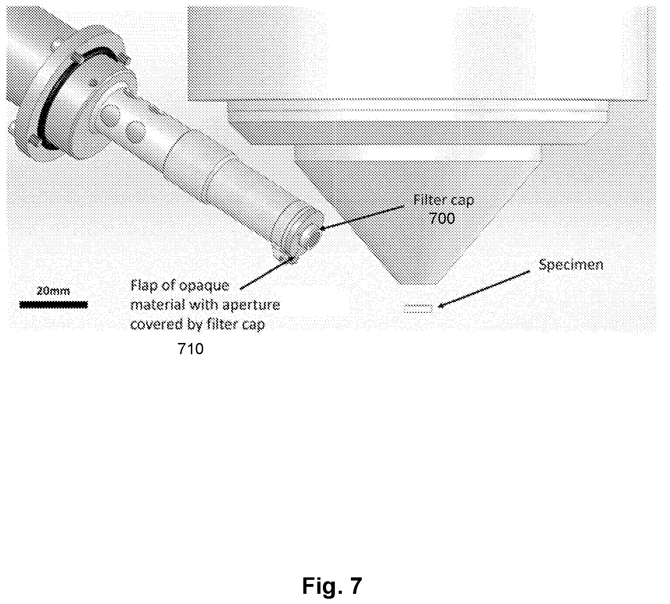

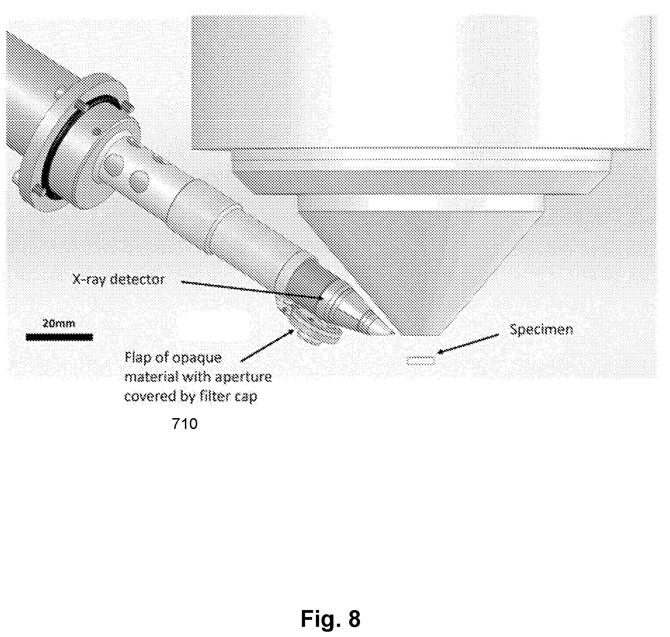

In some examples, a system is used where the EDS detector can be moved between two positions, for example, with the filter member 700 being removably attachable to a mounting element embodied as a movable flap 710 as is shown in Figures 7 and 8. In the first position, the detector is closer to the specimen than in the second position to achieve a high solid angle for collection of X-rays. This position is suitable for room temperature measurements. In a second position, the detector is retracted away from the specimen and behind a flap of material such that the filter member attenuates radiation. An aperture in the flap is provided to give the detector line of sight to the specimen and a filter member is mounted over the aperture in the flap to reduce the black body radiation from the specimen while allowing transmission of X-rays. The filter material element of the filter member itself can be mounted in a cap, as in Figure 5, and the cap fitted over the aperture. With the detector positioned behind the filter member, it is in a position suitable for in-situ heating experiments at high (>600°C), very high (>1000°C) and extremely high temperatures (>1500°C). The filter member mounted on the flap is designed to block black body radiation while allowing transmission of characteristic X-rays from the heated specimen. In this configuration the filter member could typically be positioned at a distance less than 60 mm from the sample. Thus, by having a removable filter member, the same detector can be used for acquiring a useful X-ray spectrum from a specimen heated to high temperature with the added filter in place or for acquiring an X-ray spectrum with good low-energy sensitivity from a non-heated specimen with no added filter in place.

An example of this embodiment is shown in Figures 7 and 8 where the flap 710 changes position when the detector is moved. The detector sensor is inside the end of a tube or on a support arm that can be moved on a mechanical slide to a first position where the sensor is inside an enclosure that is opaque to light apart from an opening facing the specimen which is covered by the flap 710 and can be moved to a second position on the slide that is outside of the enclosure and closer to the specimen where the flap does not restrict the passage of X-rays from the specimen to the detector.

Figure 7 shows the detector in a second position ready for in-situ heating of the specimen stage where it is retracted behind a flap assembly 710 with an aperture covered by a filter membrane as part of a filter material element that attenuates black body radiation, particularly visible light, while transmitting characteristic X-rays from the specimen.

Figure 8 shows the detector in a first position fully inserted as it would be for non-heated specimens, reaching beyond the flap assembly 710 and close to the sample specimen. In this position there is no additional filter material in place so the X-ray detection efficiency is as high as possible.

In this example embodiment, the flap 710 is held closed against the light-tight enclosure by a spring mechanism when the detector is retracted away from the specimen and the flap 710 is pushed out of the way when the detector is inserted closer to the specimen for analysis when no heating is used. Instead of a spring, the flap 710 could be supported by a hinge on the top and closed by using gravity.

With the filter member 700 mounted on a flap assembly mechanism 710 as shown in Figures 7 and 8, it is very convenient to switch the detector configuration between a first position with the detector close to the specimen and with no additional filter that maximises sensitivity to X-rays for analysis of non-heated specimens and a second position with the detector further away and with an additional filter that sacrifices some sensitivity to lower energy X-rays while strongly-attenuating black body radiation from a specimen and is at a safe distance to allow the specimen to be heated to very high temperatures up to 1500 C or above without damaging the filter or detector. This movement can be either under manual or motorised control.

In a further embodiment, rather than rely on the insertion and retraction of the detector tube to move the filter member in and out of the X-ray path from specimen to detector, the flap 710 could be implemented as a shutter mechanism that can be closed or open wherever the detector is positioned.

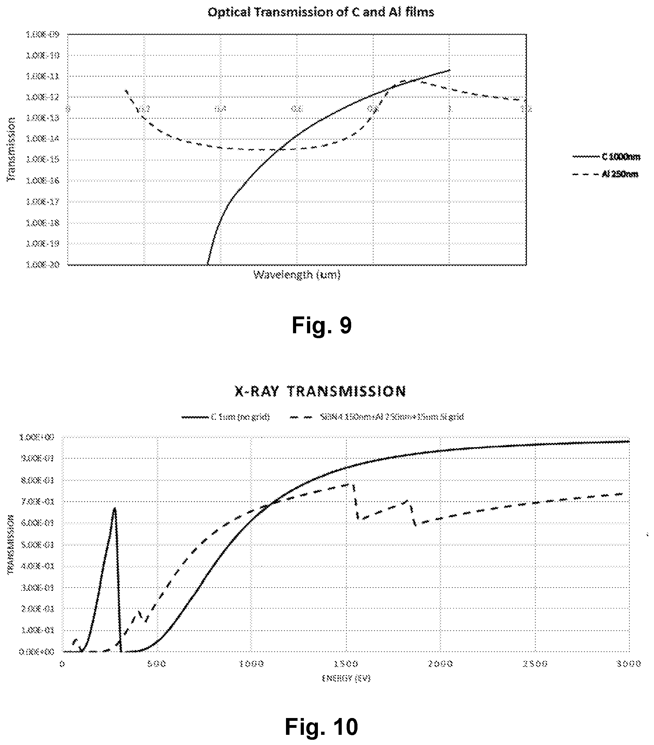

The choice of filter material and thickness is important to provide suitable attenuation of black body radiation. Examples of filter material we considered are beryllium, silicon nitride with aluminium coating, polymer (e.g. polyimide) with aluminium coating, carbon or graphene. Torma et al suggest that for a solar blind window the attenuation of light radiation should be > 10¹¹ and the calculated light transmission for a 1000 nm thick carbon filter shown in Figure 9 shows that this material should be solar blind. Figure 10 compares the X-ray transmission curve for a 1000 nm thick carbon window to that for a commercial "solar blind" window where the silicon nitride has a thickness of 150 nm and the aluminium coating has a thickness of 250 nm. A 150 nm silicon nitride film is not self-supporting and is typically supported on a silicon grid that has a thickness of 15 µm and covers about 20 % of the active area. A 1000 nm carbon film is self-supporting and does not require a grid support so at higher energies, where the film is transparent to X-rays, the overall transmission is about 20 % greater than a silicon nitride filter of the same total area. The carbon filter has useful X-ray transmission below 280eV down to 100eV (between 90% and 30% transmission) that can be used to detect X-rays from carbon and boron, whereas the silicon nitride filter has very little transmission for X-rays below 200eV and would be insensitive to these elements. However, at energies between 300 eV and 1100 eV, the silicon nitride window has better transmission. Overall, these two "solar blind" window materials offer a similar level of X-ray transmission but there are some advantages for a carbon-based window beyond X-ray transmission.

In Figure 9, the calculated optical transmission for a 1000 nm thick carbon film is compared to that for a 250 nm thick aluminium layer which provides most of the optical attenuation for the silicon nitride window used for Figure 10. The carbon film provides increasingly more attenuation for the shorter wavelength radiation that becomes more significant at very high specimen temperatures according to Figure 3.

In practice, the carbon filter can be implemented by multiple layers of graphene which gives it great strength. Besides providing a convenient self-supporting film to mount in a cap such as shown in Figure 5, the thick film is also more resilient than a brittle silicon nitride film to small particle projectiles that may break free from the heated specimen and be projected towards the film through electrostatic or mechanical force.

The thickness of a suitable carbon or graphene filter could typically range from 100 nm to 1000 nm. A 1000 nm thickness is more suitable for extremely higher temperature (>1500°C). A thickness from 100 nm to 300 nm may be adequate for specimen heating temperatures ranging from 600°C to 1000°C and an aluminium coating could also be applied to the graphene filter to provide a different compromise between X-ray transmission and optical transmission where this could benefit the application.

In some examples, multilayer coatings of different materials (e.g. metals or inorganic and organic polymer films) can form the filter material to provide a different compromise between X-ray transmission and optical transmission.

In addition to the examples provided above, systems and methods described herein may also comprise the following features:
In some examples, a system for X-ray analysis of a specimen in a particle beam instrument is provided where the specimen is on a specimen stage in a vacuum environment and the specimen is heated to a temperature of more than 100°C; where in a first mode, the analysis system comprises a detector for X-rays and an additional filter positioned between the specimen and the detector where the filter transmits X-ray photons required for analysis while providing sufficient attenuation of black body radiation to avoid saturating the X-ray detector and where the analysis system has a second mode where the filter can be removed to improve the X-ray detection efficiency for the analysis of specimens that are not heated.

In some examples, the filter is mounted across an aperture in a cap that is opaque to light and the cap is removably mounted over the entrance collimator to the detector.

In some examples, the filter is mounted across an aperture in a flap of material that is opaque to light and in a first configuration, the detector entrance collimator is behind the flap aperture so that X-rays from the specimen have to travel through the filter to reach the detector and in a second configuration the flap is moved to a position where there is no filter between the specimen and the detector entrance collimator.

In some examples, the detector is on a support arm that can be moved on a mechanical slide to a first position where the detector is inside an enclosure that is opaque to light apart from an opening facing the specimen which is covered by the flap and can be moved to a second position on the slide that is outside of the enclosure and closer to the specimen where the flap does not restrict the passage of X-rays from the specimen to the detector.

In some examples the flap is held across the opening to the enclosure with a spring tension mechanism or supported on a hinge and held in position by gravity..

In some examples, the flap can be moved in and out of a position between specimen and detector using a shutter mechanism.

In some examples the filter is made of silicon nitride or polymer with a coating of at least 200 nm of aluminium, or beryllium foil.

In some examples, the filter is made of carbon or multiple layers of graphene, with a thickness of between 100 and 1000 nm.

In some examples, the filter is held in position by friction and is free to expand and contract without causing additional mechanical stress.

In some examples, the specimen is heated to more than 1000 degrees Centigrade.

In some examples, the filter is positioned less than 60 mm from a portion of the specimen.

In some examples, the particle beam is an electron beam.

In some examples, a filter member is provided suitable for attachment to a system for X-ray analysis of a specimen in a particle beam instrument, the filter being removably attachable to the system at a position between a specimen and a detector of the system,
the filter being adapted to transmit X-ray photons required for analysis while providing sufficient attenuation of black body radiation to avoid saturating the X-ray detector of the system.

In some examples, the filter member further comprises a removable cap adapted to be fitted to an end of a detector housing of the system, the filter member being configured such that the filter is mountable to the removable cap.

In some examples, the filter member is configured to be fastened to the system by an interference fit.

In some examples, the filter member comprises a front cap, spring element, back cap, and a screw fitting for attaching the front cap to the back cap, wherein the filter member is configured such that the filter material can be held in place by friction against the spring element when the front cap is screwed together with the back cap.

In some examples, the filter comprises or is made of carbon or multiple layers of graphene, with a thickness of between 100 and 1000 nm.

## Claims

1. A system for performing energy dispersive X-ray analysis of a specimen in a particle beam instrument, the system comprising an X-ray detector and a filter member (500, 600, 700), the system adapted such that in a first operating mode, the filter member and detector are positioned so as to provide an unobstructed line of sight between the specimen and the detector, and in a second operating mode, the filter member and detector are positioned so as to obstruct the line of sight between the specimen and the detector such that in use, the portion of black body radiation emitted from the specimen that is incident upon the detector is attenuated.

2. The system according to claim 1, wherein in the first operating mode, all lines of sight between the specimen and an active area of the X-ray detector are unobstructed, and in the second operating mode, all lines of sight between the specimen and an active area of the X-ray detector are obstructed.

3. The system according to any preceding claim, wherein at least one of:
the filter member is movable between a first position relative to the detector corresponding to the first operating mode and a second position relative to the detector corresponding to the second operating mode; and
the detector is movable between a first position relative to the filter member corresponding to the first operating mode and a second position relative to the filter member corresponding to the second operating mode,
wherein the system is adapted such that in the first operating mode, the detector is positioned closer to the specimen than in the second operating mode.

4. The system according to claim any preceding claim, wherein the system comprises a mounting element (710), the mounting element comprising an aperture, and the filter member being removably attachable to the mounting element across the aperture, wherein the mounting element is movable between a first position relative to the detector corresponding to the first operating mode and a second position relative to the detector corresponding to the second operating mode, and wherein the mounting element is held in the second position with a spring tension mechanism or supported on a hinge and held in position by gravity.

5. The system according to claim 4, further comprising a motor, wherein the motor is configured to actuate movement of the mounting element between the first position relative to the detector and the second position relative to the detector.

6. The system according to claim 4 or claim 5, wherein the X-ray detector is mounted to a support arm, the support arm movable along a mechanical slide between a first position relative to the filter member and a second position relative to the filter member such that movement of the support arm from the second position to the first position towards the specimen actuates the mounting element to move between the second position and first position.

7. The system according to any preceding claim, further comprising a shutter mechanism, the shutter mechanism configured to move the filter member between a first position relative to the detector corresponding to the first operating mode and a second position relative to the detector corresponding to the second operating mode.

8. The system according to any preceding claim, wherein the filter member is configured to hold a filter material element (502) in place by at least one of a friction fit, a clearance fit, and a transition fit, wherein the filter member further comprises a removable cap (500, 600), the removable cap adapted to be fitted to the system, the filter member being configured such that the filter material element is removably mountable to the removable cap.

9. The system according to claim 8, wherein the filter member comprises a front cap portion (501), spring element (503), back cap portion (504), and a screw fitting for attaching the front cap portion to the back cap portion, wherein the filter member is configured such that the filter material element can be held in place by friction against the spring element when the front cap portion is screwed together with the back cap portion.

10. The system according to any preceding claim, wherein the filter member further comprises a magnetic electron trap, wherein the filter member is adapted such that a filter material element is insertable in a space between the electron trap and the detector.

11. The system according to any preceding claim, wherein the average thickness, along the direction between the specimen and the detector, of filter material comprised by the filter member is greater than or equal to 100 nm.

12. The system according to any preceding claim, wherein the filter member comprises one of:
silicon nitride or polymer with a coating of at least 200 nm of aluminium, or beryllium foil; and
carbon or multiple layers of graphene, with an average thickness along the direction between the specimen and the detector of between 100 nm and 1000 nm.

13. A method of performing energy dispersive X-ray analysis of a specimen
using the system according to any one of claims 1 to 12, the method comprising: selecting the first operating mode of the system;
positioning a specimen on a specimen stage inside a specimen chamber of the system;
using a particle beam assembly to generate a focused particle beam; and
monitoring, using the X-ray detector, energies of X-ray photons generated by interaction between the particle beam and the specimen.

14. A method of performing energy dispersive X-ray analysis of a specimen
using the system according to any one of claims 1 to 12, the method comprising:
selecting the second operating mode of the system;
positioning a specimen on a specimen stage inside a specimen chamber of the system;
heating the specimen to a temperature greater than or equal to 100°C; using a particle beam assembly to generate a focused particle beam; and
monitoring, using the X-ray detector, energies of X-ray photons generated by interaction between the particle beam and the specimen.

15. The method according to claim 14, wherein monitoring, using the X-ray detector, energies of X-ray photons generated by interaction between the particle beam and the specimen further comprises positioning the filter member less than 60 mm from a portion of the specimen.

## Patentansprüche

1. System zur Durchführung von energiedispersiver Röntgenanalyse einer Probe in einem Teilchenstrahl-Instrument, wobei das System einen Röntgendetektor und ein Filterelement (500, 600, 700) umfasst, wobei das System dafür geeignet ist, dass das Filterelement und der Detektor in einem ersten Betriebsmodus so positioniert werden, um eine ungehinderte Sichtlinie zwischen der Probe und dem Detektor bereitzustellen, und dass das Filterelement und der Detektor in einem zweiten Betriebsmodus so positioniert werden, um die Sichtlinie zwischen der Probe und dem Detektor derart zu blockieren, dass bei Verwendung der Teil der von der Probe emittierten Schwarzkörperstrahlung, die auf den Detektor einfällt, abgeschwächt ist.

2. System nach Anspruch 1, wobei in dem ersten Betriebsmodus alle Sichtlinien zwischen der Probe und einem aktiven Bereich des Röntgendetektors ungehindert sind und in dem zweiten Betriebsmodus alle Sichtlinien zwischen der Probe und einem aktiven Bereich des Röntgendetektors blockiert sind.

3. System nach einem vorstehenden Anspruch, wobei mindestens eines:
des Filterelements zwischen einer ersten Position in Bezug auf den Detektor, die dem ersten Betriebsmodus entspricht, und einer zweiten Position in Bezug auf den Detektor, die dem zweiten Betriebsmodus entspricht, beweglich ist; und
des Detektors zwischen einer ersten Position in Bezug auf das Filterelement, die dem ersten Betriebsmodus entspricht, und einer zweiten Position in Bezug auf das Filterelement, die dem zweiten Betriebsmodus entspricht, beweglich ist,
wobei das System dafür geeignet ist, dass in dem ersten Betriebsmodus der Detektor näher zu der Probe positioniert ist als in dem zweiten Betriebsmodus.

4. System nach einem vorstehenden Anspruch, wobei das System ein Befestigungselement (710) umfasst, wobei das Befestigungselement eine Öffnung umfasst und das Filterelement abnehmbar an das Befestigungselement über die Öffnung anbringbar ist, wobei das Befestigungselement zwischen einer ersten Position in Bezug auf den Detektor, die dem ersten Betriebsmodus entspricht, und einer zweiten Position in Bezug auf den Detektor, die dem zweiten Betriebsmodus entspricht, beweglich ist und wobei das Befestigungselement in der zweiten Position mit einem Federspannmechanismus gehalten wird oder an einem Gelenk gestützt wird und durch Schwerkraft in Position gehalten wird.

5. System nach Anspruch 4, das weiter einen Motor umfasst, wobei der Motor zur Auslösung einer Bewegung des Befestigungselements zwischen der ersten Position in Bezug auf den Detektor und der zweiten Position in Bezug auf den Detektor konfiguriert ist.

6. System nach Anspruch 4 oder Anspruch 5, wobei der Röntgendetektor an einem Stützarm befestigt ist, wobei der Stützarm entlang eines mechanischen Schiebers zwischen einer ersten Position in Bezug auf das Filterelement und einer zweiten Position in Bezug auf das Filterelement derart beweglich ist, dass eine Bewegung des Stützarms von der zweiten Position zu der ersten Position in Richtung der Probe eine Bewegung des Befestigungselements zwischen der zweiten Position und ersten Position auslöst.

7. System nach einem vorstehenden Anspruch, das weiter einen Blendenmechanismus umfasst, wobei der Blendenmechanismus zur Bewegung des Filterelements zwischen einer ersten Position in Bezug auf den Detektor, die dem ersten Betriebsmodus entspricht, und einer zweiten Position in Bezug auf den Detektor, die dem zweiten Betriebsmodus entspricht, konfiguriert ist.

8. System nach einem vorstehenden Anspruch, wobei das Filterelement zum Halten eines Filtermaterialelements (502) in Position durch mindestens eine einer Reibungspassung, einer Spielpassung und einer Übergangspassung konfiguriert ist, wobei das Filterelement weiter eine abnehmbare Kappe (500, 600) umfasst, wobei die abnehmbare Kappe zur Passung auf das System geeignet ist, wobei das Filterelement derart konfiguriert ist, dass das Filtermaterialelement abnehmbar auf die abnehmbare Kappe anbringbar ist.

9. System nach Anspruch 8, wobei das Filterelement einen vorderen Kappenteil (501), ein Federelement (503), einen hinteren Kappenteil (504) und eine Schraubfassung zur Anbringung des vorderen Kappenteils an das hintere Kappenteil umfasst, wobei das Filterelement derart konfiguriert ist, dass das Filtermaterialelement durch Reibung gegen das Federelement in Position gehalten werden kann, wenn der vordere Kappenteil mit dem hinteren Kappenteil zusammengeschraubt ist.

10. System nach einem vorstehenden Anspruch, wobei das Filterelement weiter eine magnetische Elektronenfalle umfasst, wobei das Filterelement derart geeignet ist, dass ein Filtermaterialelement in einen Raum zwischen der Elektronenfalle und dem Detektor einführbar ist.

11. System nach einem vorstehenden Anspruch, wobei die durchschnittliche Dicke, entlang der Richtung zwischen der Probe und dem Detektor, von Filtermaterial, das in dem Filterelement enthalten ist, größer als oder gleich 100 nm ist.

12. System nach einem vorstehenden Anspruch, wobei das Filterelement eines von Folgenden umfasst:
Siliciumnitrid oder Polymer mit einer Beschichtung von mindestens 200 nm Aluminium- oder Berylliumfolie; und
Kohlenstoff oder mehrere Schichten von Graphen mit einer durchschnittlichen Dicke entlang der Richtung zwischen der Probe und dem Detektor von zwischen 100 nm und 1000 nm.

13. Verfahren zur Durchführung von energiedispersiver Röntgenanalyse einer Probe unter Verwendung des Systems nach einem der Ansprüche 1 bis 12, wobei das Verfahren Folgendes umfasst:
Auswählen des ersten Betriebsmodus des Systems;
Positionieren einer Probe auf einem Probentisch im Inneren einer Probenkammer des Systems;
Verwenden einer Teilchenstrahlvorrichtung, um einen fokussierten Teilchenstrahl zu erzeugen; und
Überwachen, unter Verwendung des Röntgendetektors, von Energien von Röntgenphotonen, die durch Wechselwirkung zwischen dem Teilchenstrahl und der Probe erzeugt werden.

14. Verfahren zur Durchführung von energiedispersiver Röntgenanalyse einer Probe unter Verwendung des Systems nach einem der Ansprüche 1 bis 12, wobei das Verfahren Folgendes umfasst:
Auswählen des zweiten Betriebsmodus des Systems;
Positionieren einer Probe auf einem Probentisch im Inneren einer Probenkammer des Systems;
Erhitzen der Probe auf eine Temperatur von größer als oder gleich 100 °C;
Verwenden einer Teilchenstrahlvorrichtung, um einen fokussierten Teilchenstrahl zu erzeugen; und
Überwachen, unter Verwendung des Röntgendetektors, von Energien von Röntgenphotonen, die durch Wechselwirkung zwischen dem Teilchenstrahl und der Probe erzeugt werden.

15. Verfahren nach Anspruch 14, wobei das Überwachen, unter Verwendung des Röntgendetektors, von Energien von Röntgenphotonen, die durch Wechselwirkung zwischen dem Teilchenstrahl und der Probe erzeugt werden, weiter das Positionieren des Filterelements weniger als 60 mm von einem Teil der Probe umfasst.

## Revendications

1. Système destiné à effectuer une analyse par dispersion d'énergie des rayons X d'un échantillon dans un instrument à faisceau de particules, le système comprenant un détecteur de rayons X et un membre de filtre (500, 600, 700), le système étant adapté de sorte que dans un premier mode de fonctionnement, le membre de filtre et le détecteur sont positionnés de manière à fournir une ligne de vue dégagée entre l'échantillon et le détecteur, et dans un deuxième mode de fonctionnement, le membre de filtre et le détecteur sont positionnés de manière à obstruer la ligne de vue entre l'échantillon et le détecteur de sorte qu'en emploi la partie de rayonnement de corps noir émis de l'échantillon qui est incidente sur le détecteur est atténuée.

2. Système selon la revendication 1, dans lequel dans le premier mode de fonctionnement, toutes les lignes de vue entre l'échantillon et une zone active du détecteur de rayons X sont dégagées, et dans le deuxième mode de fonctionnement, toutes les lignes de vue entre l'échantillon et une zone active du détecteur de rayons X sont obstruées.

3. Système selon l'une quelconque des revendications précédentes, dans lequel au moins l'un d'entre :
le membre de filtre est amovible entre une première position par rapport au détecteur correspondant au premier mode de fonctionnement et une deuxième position par rapport au détecteur correspondant au deuxième mode de fonctionnement ; et
le détecteur est amovible entre une première position par rapport au membre de filtre correspondant au premier mode de fonctionnement et une deuxième position par rapport au membre de filtre correspondant au deuxième mode de fonctionnement,
où le système est adapté de sorte que dans le premier mode de fonctionnement, le détecteur est positionné plus près de l'échantillon que dans le deuxième mode de fonctionnement.

4. Système selon l'une quelconque des revendications précédentes, dans lequel le système comprend un élément de montage (710), l'élément de montage comprenant une ouverture, et le membre de filtre étant attachable de manière amovible à l'élément de montage à travers l'ouverture, dans lequel l'élément de montage est amovible entre une première position par rapport au détecteur correspondant au premier mode de fonctionnement et une deuxième position par rapport au détecteur correspondant au deuxième mode de fonctionnement, et dans lequel l'élément de montage est maintenu dans la deuxième position par un mécanisme de tension à ressort ou soutenu sur une charnière et maintenu en position par gravité.

5. Système selon la revendication 4, comprenant en outre un moteur, dans lequel le moteur est configuré pour actionner le mouvement de l'élément de montage entre la première position par rapport au détecteur et la deuxième position par rapport au détecteur.

6. Système selon la revendication 1 ou la revendication 5, dans lequel le détecteur de rayons X est monté sur un bras de support, le bras de support étant amovible le long d'une glissière mécanique entre une première position par rapport au membre de filtre et une deuxième position par rapport au membre de filtre de sorte que le mouvement du bras de support de la deuxième position à la première position vers l'échantillon actionne l'élément de montage pour qu'il se déplace entre la deuxième position et la première position.

7. Système selon l'une quelconque des revendications précédentes, comprenant en outre un mécanisme d'obturation, le mécanisme d'obturation étant configuré pour déplacer le membre de filtre entre une première position par rapport au détecteur correspondant au premier mode de fonctionnement et une deuxième position par rapport au détecteur correspondant au deuxième mode de fonctionnement.

8. Système selon l'une quelconque des revendications précédentes, dans lequel le membre de filtre est configuré pour tenir en place un élément de matériau filtrant (502) par au moins l'un d'entre un ajustement par friction, un ajustement avec jeu et un ajustement par transition, dans lequel le membre de filtre comprend en outre un bouchon amovible (500, 600), le bouchon amovible étant adapté pour être ajusté au système, le membre de filtre étant configuré de sorte que l'élément de matériau filtrant peut être monté de manière amovible dans le bouchon amovible.

9. Système selon la revendication 8, dans lequel le membre de filtre comprend une partie de bouchon avant (501), un élément à ressort (503), une partie de bouchon arrière (504), et un raccord à vis pour attacher la partie de bouchon avant à la partie de bouchon arrière, dans lequel le membre de filtre est configuré de sorte que l'élément de matériau filtrant peut être tenu en place par friction contre l'élément à ressort lorsque la partie de bouchon avant est vissée avec la partie de bouchon arrière.

10. Système selon l'une quelconque des revendications précédentes, dans lequel le membre de filtre comprend en outre un piège magnétique à électrons, dans lequel le membre de filtre est adapté de sorte qu'un élément de matériau filtrant peut être inséré dans un espace entre le piège à électrons et le détecteur.

11. Système selon l'une quelconque des revendications précédentes, dans lequel l'épaisseur moyenne, le long de la direction entre l'échantillon et le détecteur, de matériau filtrant compris dans le membre de filtre est supérieure ou égale à 100 nm.

12. Système selon l'une quelconque des revendications précédentes, dans lequel le membre de filtre comprend l'un d'entre :
du nitrure de silicium ou polymère avec un revêtement d'au moins 200 nm en feuille d'aluminium ou de béryllium ; et
du carbone ou des couches multiples de graphène, d'une épaisseur moyenne le long de la direction entre l'échantillon et le détecteur d'entre 100 nm et 1000 nm.

13. Procédé pour effectuer une analyse par dispersion d'énergie des rayons X d'un échantillon en utilisant le système selon l'une quelconque des revendications 1 à 12, le procédé comprenant :
sélectionner le premier mode de fonctionnement du système ;
positionner un échantillon sur une platine porte-échantillon dans une chambre à échantillons du système ;
utiliser un ensemble de faisceau de particules pour générer un faisceau de particules focalisé ; et
surveiller, avec le détecteur de rayons X, les énergies des photons des rayons X générés par l'interaction entre le faisceau de particules et l'échantillon.

14. Procédé pour effectuer une analyse par dispersion d'énergie des rayons X d'un échantillon en utilisant le système selon l'une quelconque des revendications 1 à 12, le procédé comprenant :
sélectionner le deuxième mode de fonctionnement ;
positionner un échantillon sur une platine porte-échantillon dans une chambre à échantillons du système ;
chauffer l'échantillon à une température supérieure ou égale à 100 °C ;
utiliser l'ensemble de faisceau de particules pour générer un faisceau de particules focalisé ; et
surveiller, avec le détecteur de rayons X, les énergies des photons des rayons X générés par l'interaction entre le faisceau de particules et l'échantillon.

15. Procédé selon la revendication 14, dans lequel, surveiller, avec le détecteur de rayons X, les énergies des photons des rayons X générés par l'interaction entre le faisceau de particules et l'échantillon comprend en outre positionner le membre de filtre à moins de 60 mm d'une partie de l'échantillon.
